# EUROPÄISCHE PATENTANMELDUNG

(11) **EP 4 697 602 A1**
(43) Veröffentlichungstag der Anmeldung: **18.02.2026**
(21) Anmeldenummer: 25185460.0
(22) Anmeldetag: 26.06.2025
(51) Int. Cl.: H03K 17/687

(54) **COMMON-SOURCE-KONFIGURATION VON ZWEI TRANSISTOREN**

(30) Priorität: 14.08.2024 DE 102024207757
(71) Anmelder: Siemens Aktiengesellschaft, 80333 München (DE)
(72) Erfinder: Breiter, Julian Stefan, 93059 Regensburg (DE); Handt, Karsten, 92348 Berg (DE); Nannen, Hauke, 90475 Nürnberg (DE)
(74) Vertreter: Siemens Patent Attorneys

(57) **Zusammenfassung**

Die Erfindung betrifft eine Common-Source-Konfiguration von zwei Transistoren (T1, T2) mit je einem Quellen-Anschluss (S1), einem Senken-Anschluss (D1) und einem Steuer-Anschluss (G1), aufweisend
- zwei Steuer-Stromkreise (31, 32) zur Steuerung je eines der Transistoren (T1, T2), um einen Laststrom durch die Common-Source-Konfiguration zu steuern,
- einen Hauptstrompfad (10) des Laststroms, und
- einen Nebenstrompfad (12) des Laststroms, der parallel zu einem Abschnitt des Hauptstrompfads (10) verläuft,

wobei in mindestens einem der Steuer-Stromkreise (31, 32) ein oder mehrere Steuer-Vorwiderstände (R1, R2, R12) angeordnet sind,
wobei die Quellen-Anschlüsse (S1, S2) elektrisch verbunden sind,
wobei die beiden Senken-Anschlüsse (D1, D2) und die beiden Quellen-Anschlüsse (S1, S2) in dem Hauptstrompfad (10) liegen,
wobei parallel zu einem Teilstück des Hauptstrompfades (10) der Nebenstrompfad (12) verläuft, dessen eine Hälfte durch ein Teilstück des ersten Steuer-Stromkreises (31) und dessen andere Hälfte durch ein Teilstück des zweiten Steuer-Stromkreises (32) gebildet wird,
dadurch gekennzeichnet,
dass mindestens einer der besagten Steuer-Vorwiderstände im Nebenstrompfad (12) angeordnet ist.

## Beschreibung

### Technisches Gebiet

Die vorliegende Erfindung betrifft eine Common-Source-Konfiguration von zwei Transistoren.

### Technischer Hintergrund

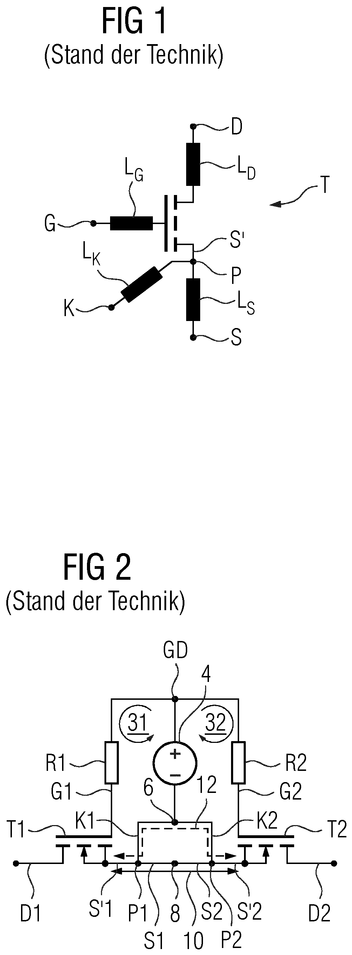

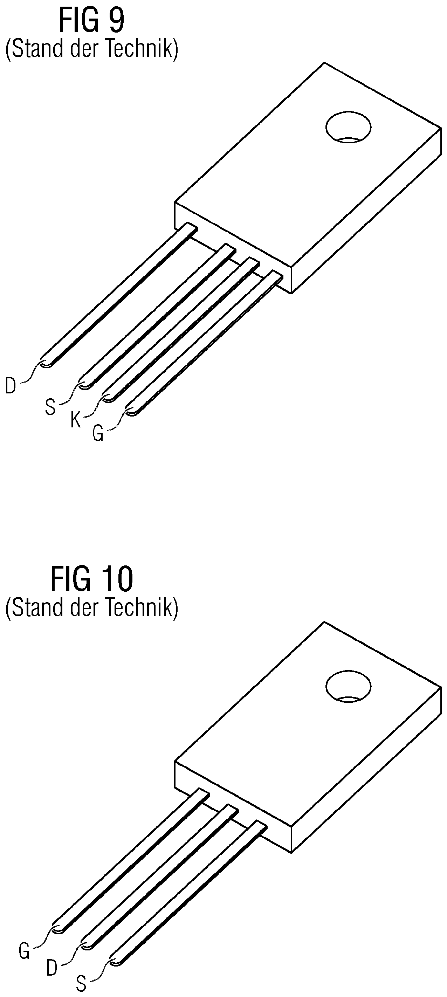

Es sind MOSFETs bekannt, die außer dem Drain-Pin, dem Source-Pin und dem Gate-Pin noch einen weiteren Pin, den sogenannten "Kelvin-Pin", aufweisen, siehe Fig. 1 und Fig. 9. Dieser vierte Pin ermöglicht es, den Gate-Steuerkreis an der Induktivität des Source-Pins vorbeizuführen und somit die Gate-Ansteuerung, d. h. den Gate-Steuerkreis, vom Laststromkreis zu entkoppeln; damit wird eine Erhöhung der Schaltgeschwindigkeit und eine Abnahme der erforderlichen Schaltenergie, somit eine signifikante Verbesserung des Schaltverhaltens möglich. Da der zusätzliche Kelvin-Pin viele Vorteile hat, statten Hersteller von Halbleiter-Bauelementen immer mehr MOSFETs mit einem Kelvin-Pin aus und bieten teilweise für das Standardgehäuse (through-hole package) TO-247 keine MOSFETs mit lediglich drei Pins für Drain, Source und Gate, wie in Fig. 10 dargestellt, mehr an. Da sowohl der Kelvin-Pin als auch der Source-Pin im Inneren des Transistors auf dem "bare die" mit dem Source-Anschluss des Transistors verbunden sind, kann zur besseren Unterscheidung der Kelvin-Pin auch als Kelvin-Source-Anschluss oder -Pin, oder als Hilfs-Source-Anschluss oder -Pin, und der Source-Pin als Power-Source-Anschluss oder -Pin bezeichnet werden. Die Bezeichnung "Power-Source-Anschluss" oder "Power-Source-Anschluss" wird deswegen verwendet, weil über diesen Anschluss der Laststrom fließt, wohingegen über den Kelvin-Source-Anschluss der signifikant geringere Gatesteuerstrom fließt.

Eine Beschreibung dieses Sachverhalts findet man in dem Zeitschriftenartikel "Potenzial von SiC voll ausschöpfen. SMD-MOSFETs mit Kelvin-Source-Pin" der Zeitschrift "emobility tec", Ausgabe 01/2019, Autoren: Christian Felgemacher, Felipe Filsecker, Farhan Beg, Aly Mashaly, Seiya Kitagawa, Seiten 14-17, Hüthig Medien GmbH, Heidelberg, Germany, 2019, https://www.rohm.de/documents/4392907/6355683/emobilitytec_0119_080319_Coverstory.pdf/ ed87c1ee-02e2-a6ce-5f27-6785fd8405b5?t=1586410136257 (Online abgerufen am 13.03.2024).

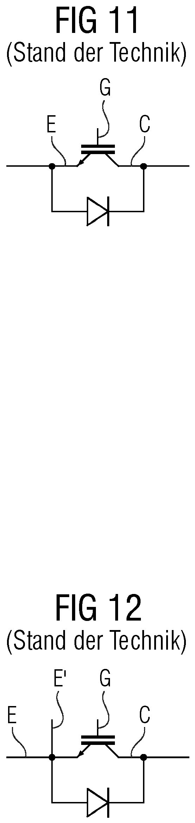

Nicht nur MOSFET, sondern auch andere Bautypen von Transistoren können einen solchen vierten Pin aufweisen. Zum Beispiel zeigt Fig. 12 einen 4-Pin-IGBT mit einer parallel geschalteten Diode, gegenüber einem in Fig. 11 dargestellten 3-Pin-IGBT mit einer parallel geschalteten Diode. Bei einem IGBT wird der vierte Pin als Kelvin-Emitter bezeichnet.

Weitere Informationen zu diesem Sachverhalt findet man außerdem in der Publikation "TRENCHSTOP™ 5 IGBT in a Kelvin Emitter Configuration. Performance Comparison and Design Guidelines", Application Note, Revision 1.0, Datum 2014-10-16, 12 Seiten, Infineon Technologies AG, München, Germany, 2014, https://www.infineon.com/dgdl/Infineon-TRENCHSTOP5_in_TO-247-4pin-ApplicationNotes-v01_00-EN.pdf?fileld =5546d4624933b875014974f4d97e09ea (Online abgerufen am 13.03.2024).

In bidirektionalen Schaltapplikationen (AC-Switching), wo es notwendig ist, sowohl positive als auch negative Ströme bzw. Spannungen zu schalten, ist die Common-Source- bzw. Common-Emitter-Konfiguration (auch als Common-Source- bzw. Common-Emitter-Schaltung bezeichnet) eine der am weitesten verbreiteten Schaltungskonfigurationen; sie wird auch als "back-to-back"-Konfiguration bzw. -Schaltung bezeichnet (AC = Alternating Current). Ein Ausführungsbeispiel einer solchen Common-Source-Konfiguration ist in der EP 1 271 743 A2 (Siemens AG) 02.01.2003 beschrieben. Die Common-Source- bzw. Common-Emitter-Konfiguration hat unter anderem den Vorteil, dass nur ein einziges Steuersignal für beide Transistoren erforderlich ist, d. h., dass für eine Ansteuerung des bidirektionalen Halbleiterschalters ein einkanaliger Gatetreiber ausreichend ist.

Möchte man in der Common-Source- bzw. Common-Emitter-Konfiguration, in der zwei Transistoren "back-to-back" miteinander verbunden werden, die Vorteile des Kelvin-Anschlusses nutzen, müssen die Kelvin-Source- bzw. Kelvin-Emitter-Anschlüsse der beiden Transistoren miteinander verbunden werden; sie bilden dann das Bezugspotential des Gatetreibers. Eine standardmäßige Schaltung einer Gateansteuerung beinhaltet einen Gatetreiber, der eine Ausgangsspannung bzw. einen Ausgangsstrom bereitstellt, und mindestens einen Gatevorwiderstand, mit dem das Schaltverhalten des Gatetreibers angepasst werden kann. Dieser Gatevorwiderstand befindet sich zwar, wie der Name sagt, in der Regel vor dem Gate-Anschluss, es ist für die Anpassung der Gateansteuerung aber ausreichend, wenn er an irgendeiner Stelle im Gate-Steuerkreis angeordnet ist. Da der Kelvin-Source-Anschluss und der Power-Source-Anschluss im Inneren des Transistors miteinander verbunden sind, bildet sich nun über die beiden Kelvin-Source-Anschlüsse ein zum Laststrompfad paralleler Nebenstrompfad aus, siehe Fig. 2; durch den Nebenstrompfad fließt ein Teil des Hauptstromes. Die Aufteilung des Stromes auf den Laststrompfad und den Nebenstrompfad ist im Wesentlichen von den internen Eigenschaften des Halbleiters abhängig, z. B. den elektrischen Widerständen im Laststrompfad und im Nebenstrompfad. Der Nebenstrompfad ist jedoch nicht für hohe und andauernde Ströme ausgelegt, weshalb Hersteller üblicherweise sogar davon abraten, die Kelvin-Anschlüsse in Common-Source-Konfigurationen zu verwenden.

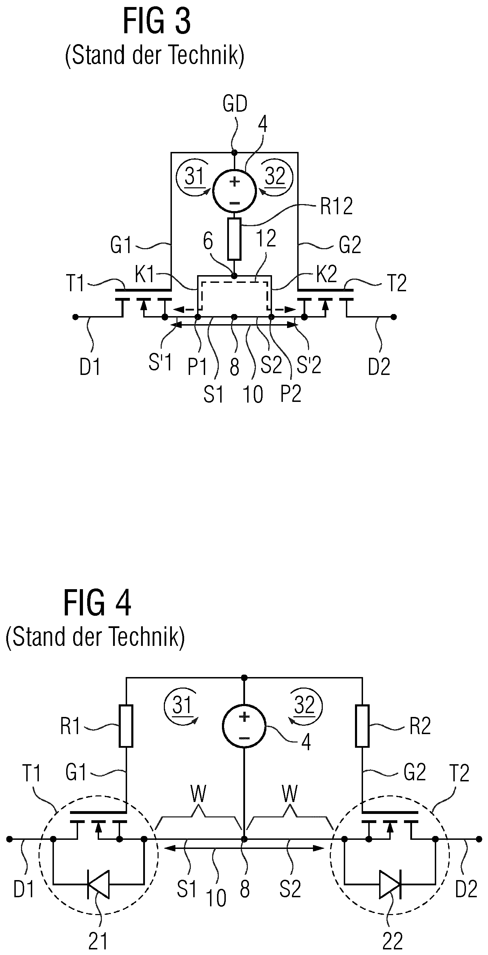

Ein Nebenstrompfad kann aber nicht nur bei Transistoren mit Kelvin-Source- bzw. Kelvin-Emitter-Anschlüssen in Common-Source- bzw. Common-Emitter-Schaltung ("back-to-back"-Schaltung) entstehen, sondern generell bei allen Common-Source- bzw. Common-Emitter-Schaltungen. Der Gate-Steuerkreis wird in einer Common-Source- bzw. Common-Emitter-Schaltung nämlich immer über den Source- bzw. Emitter-Anschluss geführt. Je nach Art der Verbindung des Gate-Steuerkreises mit dem Source- bzw. Emitter-Anschluss kann sich in einer Common-Source- bzw. Common-Emitter-Schaltung ein Nebenstrompfad ausbilden, der nicht für den Laststrom ausgelegt ist, siehe Fig. 3 bis 5.

### Zusammenfassung der Erfindung

Der vorliegenden Erfindung liegt die Aufgabe zugrunde, eine verbesserte Common-Source- bzw. Common-Emitter-Konfiguration bereitzustellen. Zur Vereinfachung wird im Folgenden nur der Begriff Common-Source-Konfiguration verwendet; er umfasst eine back-to-back-Schaltung von zwei beliebigen Transistorentypen, bei denen die Source- bzw. Emitter-Anschlüsse der Transistoren miteinander elektrisch verbunden sind.

Diese Aufgabe wird erfindungsgemäß durch eine Common-Source-Konfiguration mit den in Anspruch 1 angegebenen Merkmalen gelöst. Die Common-Source-Konfiguration ist eine back-to-back-Verschaltung von zwei Transistoren, mit anderen Worten: ein bidirektionaler Halbleiterschalter aus zwei Transistoren, deren Source- bzw. Emitter Anschlüsse miteinander elektrisch verbunden sind. Die Common-Source-Konfiguration weist zwei Steuer-Stromkreise zur Steuerung je einer der Transistoren auf, d. h. ein erster der zwei Steuer-Stromkreise ist zur Steuerung eines ersten der zwei Transistoren ausgebildet und ein zweiter der zwei Steuer-Stromkreise ist zur Steuerung eines zweiten der zwei Transistoren ausgestaltet. Die Steuerung der Transistoren erfolgt, um einen Laststrom durch die Common-Source-Konfiguration zu steuern. Die erfindungsgemäße Common-Source-Konfiguration wird im Folgenden auch als bidirektionaler Halbleiterschalter oder einfach als Schalter bezeichnet.

Die Common-Source-Konfiguration der zwei Transistoren weist einen Hauptstrompfad des Laststroms auf. Außerdem weist die Common-Source-Konfiguration der zwei Transistoren einen Nebenstrompfad des Laststroms auf, wobei der Nebenstrompfad parallel zu einem Abschnitt des Hauptstrompfads verläuft. Der Nebenstrompfad wird durch die Verschaltung der zwei Steuer-Stromkreise gebildet. In mindestens einem der Steuer-Stromkreise sind ein oder mehrere Steuer-Vorwiderstände angeordnet. Mindestens einer der besagten Steuer-Vorwiderstände ist im Nebenstrompfad angeordnet. Der mindestens eine der Steuer-Vorwiderstände ist also in einem Abschnitt des Nebenstrompfads angeordnet, der zugleich einen Abschnitt eines der Steuer-Stromkreise bildet.

Gemäß der Erfindung weist ein erster Transistor der zwei Transistoren einen ersten Quellen-Anschluss, einen ersten Senken-Anschluss und einen ersten Steuer-Anschluss auf. Ein zweiter Transistor der zwei Transistoren weist einen zweiten Quellen-Anschluss, einen zweiten Senken-Anschluss und einen zweiten Steuer-Anschluss auf. Die beiden Quellen-Anschlüsse sind elektrisch verbunden. Die beiden Senken-Anschlüsse und die beiden Quellen-Anschlüsse liegen in dem Hauptstrompfad. In einem ersten Steuer-Stromkreis der Steuer-Stromkreise, der zur Steuerung des ersten Transistors ausgebildet ist, liegt eine erste Steuereinheit, ein erster Steuer-Vorwiderstand und der erste Steuer-Anschluss. In einem zweiten Steuer-Stromkreis der Steuer-Stromkreise, der zur Steuerung des zweiten Transistors dient, liegt eine zweite Steuereinheit, ein zweiter Steuer-Vorwiderstand und der zweite Steuer-Anschluss. Parallel zu einem Teilstück des Hauptstrompfades verläuft der Nebenstrompfad, dessen eine Hälfte durch ein Teilstück des ersten Steuer-Stromkreises und dessen andere Hälfte durch ein Teilstück des zweiten Steuer-Stromkreises gebildet wird.

Der Erfindung liegt der Gedanke zugrunde, dass ein Laststrom über den Nebenstrompfad unerwünscht ist, da der Nebenstrompfad nicht für den Laststrom ausgelegt ist und auch einen störenden Schwingkreis bilden kann: Ein großes Problem ist das Schwingverhalten dieser zwei parallelen Strompfade, des Hauptstrompfads und des Nebenstrompfads. Der Nebenstrompfad ist in der Regel länger und dünner und hat somit eine größere parasitäre Induktivität. Mit der Gatekapazität im Steuer-Stromkreis führt das in vielen Fällen zu einem unerwünschten Schwingkreis. Daher wird erfindungsgemäß mindestens ein Steuer-Vorwiderstand in dem Nebenstrompfad angeordnet: da die Anschluss-Pins selbst durch ihren internen Aufbau so niederohmig wie nur möglich ausgeführt werden (z. B. Werte < 1 mOhm) und die Steuer-Vorwiderstände, die auch als Gatevorwiderstand bezeichnet werden, üblicherweise im ein- bis maximal zweistelligen Ohm-Bereich liegen, fließt also nur noch ein relativ geringer, vorzugsweise vernachlässigbarer Teil des Laststroms über den Nebenstrompfad, der weitaus größte Anteil des Laststroms aber über den für den Laststrom ausgelegten Hauptstrompfad.

Der erfindungsgemäße bidirektionale Halbleiterschalter ist für Anwendungen geeignet, in denen elektrischer Strom in beiden Richtungen fließt; er ist also in AC-Anwendungen, aber auch in DC-Anwendungen mit bidirektionalem Stromfluss einsetzbar (DC = Direct Current). Der Schalter weist zwei Transistoren auf. Bei den Transistoren kann es sich um Bipolartransistoren, FET (z. B. MOSFET, JFET, SIT), IGBT, GTO, IGCT oder um andere Typen von Transistoren handeln. Bei den unterschiedlichen Transistortypen tragen die elektrischen Anschlüsse des Transistors, die durch aus dem Transistorgehäuse ragende Stifte (engl.: Pins), Drähte oder Bleche realisiert sein können, unterschiedliche Bezeichnungen, die zum besseren Verständnis in der Tabelle 1 einander gegenübergestellt sind. Da die vorliegende Erfindung mit unterschiedlichen Transistortypen ausgeführt sein kann, ohne dass ein spezifischer Transistortyp bevorzugt ist, werden in dieser Beschreibung der Erfindung für die elektrischen Anschlüsse des Transistors die verallgemeinerten Bezeichnungen "Quellen-Anschluss", "Senken-Anschluss" und "Steuer-Anschluss" verwendet, die in der ersten Spalte der Tabelle 1 angegeben sind.

**Tabelle 1: Bezeichnungen für die elektrischen Anschlüsse von 3-Pin-Transistoren**

| Transistor | Bipolartransistor | FET (MOSFET, JFET, SIT, etc.) | IGBT |
|---|---|---|---|
| Quellen-Anschluss | Emitter E | Source S | Emitter E |
| Senken-Anschluss | Kollektor C | Drain D | Kollektor C |
| Steuer-Anschluss | Basis B | Gate G | Gate G |

### Ausgestaltungen der Erfindung

Vorteilhafte Ausgestaltungen und Weiterbildungen der Erfindung sind in den abhängigen Ansprüchen angegeben.

Gemäß einer bevorzugten Ausgestaltung der Erfindung sind die erste Steuereinheit und die zweite Steuereinheit identisch. Von Vorteil ist dabei, dass die Ansteuerung der zwei Transistoren der Common-Source-Konfiguration mit lediglich einer einzigen Steuereinheit, z. B. einem einkanaligen Gatetreiber, funktioniert.

Gemäß einer bevorzugten Ausgestaltung der Erfindung sind die zwei Transistoren jeweils als ein 4-Pin-Transistor ausgebildet und weisen jeweils einen Steuer-Anschluss, einen Senken-Anschluss, und zwei Quellen-Anschlüsse auf, wobei ein erster der Quellen-Anschlüsse als Power-Quellen-Anschluss und ein zweiter der Quellen-Anschlüsse als Kelvin-Quellen-Anschluss bezeichnet wird. Dabei wird der Nebenstrompfad durch die beiden miteinander verbundenen Kelvin-Quellen-Anschlüsse gebildet.

Es handelt es sich bei dem Power-Quellen-Anschluss und dem Kelvin-Quellen-Anschluss um zwei Transistor-Anschlüsse, die beide an einem Verzweigungspunkt mit dem internen Quellen-Anschluss des Transistors (= Emitter (Bipolartransistor), = Source (MOSFET), = Emitter (IGBT)) elektrisch verbunden sind. Das heißt, auch bei den Transistoren mit vier von außen elektrisch kontaktierbaren Anschlüssen erfolgt die Steuerung des Stroms oder der Spannung mithilfe von drei internen Anschlüssen, aber der interne Quellen-Anschluss des Transistors verzweigt sich auf seinem Strompfad nach außen in zwei Anschlüsse, nämlich den Power-Quellen-Anschluss und den Kelvin-Quellen-Anschluss. Dabei befindet sich der Verzweigungspunkt immer auf dem "bare die" des Transistors, sonst macht es technisch keinen Sinn.

Da die vorliegende Erfindung mit unterschiedlichen 4-Pin-Transistorarten ausgeführt sein kann, ohne dass eine spezifische Transistorart bevorzugt ist, werden in dieser Beschreibung der Erfindung für die vier elektrischen Anschlüsse der gemäß der Erfindung eingesetzten 4-Pin-Transistoren die verallgemeinerten Bezeichnungen "Power-Quellen-Anschluss", "Kelvin-Quellen-Anschluss", "Senken-Anschluss" und "Steuer-Anschluss" verwendet, die in der ersten Spalte der Tabelle 2 angegeben sind.

**Tabelle 2: Bezeichnungen für die elektrischen Anschlüsse von 4-Pin-Transistoren**

| Transistor | Bipolartransistor | FET (MOSFET, JFET, SIT, etc.) | IGBT |
|---|---|---|---|
| Power-Quellen-Anschluss | Power-Emitter E | Power-Source S | Power-Emitter E |
| Kelvin-Quellen-Anschluss / Kelvin-Anschluss | Kelvin-Emitter E | Kelvin-Source S | Kelvin-Emitter E |
| Senken-Anschluss | Kollektor C | Drain D | Kollektor C |
| Steuer-Anschluss | Basis B | Gate G | Gate G |

Gemäß einer bevorzugten Ausgestaltung der Erfindung sind die Kelvin-Quellen-Anschlüsse der zwei 4-Pin-Transistoren elektrisch miteinander verbunden. Die zwei 4-Pin-Transistoren sind also auf eine Weise miteinander verschaltet, die üblicherweise als Common-Source-Konfiguration bezeichnet wird.

Gemäß einer bevorzugten Ausgestaltung der Erfindung ist in der elektrischen Verbindung der Kelvin-Quellen-Anschlüsse mindestens ein Steuer-Vorwiderstand angeordnet. Im Stand der Technik, d. h. bei einer herkömmlichen Common-Source-Konfiguration, weist eine übliche ("standardmäßige") Beschaltung des Steuer-Anschlusses (oft als "Gatebeschaltung" bezeichnet) im Wesentlichen eine Reihenschaltung eines Steueranschluss-Treibers (= Spannungsquelle), eines Steuer-Vorwiderstands (auch als "Steueranschluss-Vorwiderstand" oder "Gate-Vorwiderstand" bezeichnet) und des Halbleiter-Ansteuerkontakts "Steueranschluss" auf. Durch den Steuer-Vorwiderstand kann die Art und Weise optimiert werden, wie der Halbleiter-Ansteuerkontakt "Steueranschluss" durch den Steueranschluss-Treiber angesteuert wird.

Gemäß einer bevorzugten Ausgestaltung der Erfindung werden nun diese Steuer-Vorwiderstände aus den Beschaltungen der Steuer-Anschlüsse, wo sie bei einer herkömmlichen Common-Source-Konfiguration angeordnet sind, entfernt und stattdessen in die elektrische Verbindung der Kelvin-Quellen-Anschlüsse verschoben. Durch die erfindungsgemäße Verschiebung der Steuer-Vorwiderstände von den Steuer-Anschlüssen zu den Kelvin-Quellen-Anschlüsse ändert sich mathematisch nichts an den Spannungsverhältnissen. Lediglich der Bezugspunkt (GND) des Steueranschluss-Treibers liegt nun nicht mehr auf dem gemeinsamen Source-Potential, sondern auf dem virtuellen GND-Potential nach den Steuer-Vorwiderständen, die wegen ihrer Umplatzierung nun auch Quellenanschluss-Vorwiderstände genannt werden könnten.

Der bevorzugten Ausgestaltung der Erfindung liegt die Erkenntnis zugrunde, dass eine Verschiebung der Steuer-Vorwiderstände von den Steuer-Anschlüssen zu den Kelvin-Quellen-Anschlüssen nichts an den Spannungsverhältnissen ändert, aber den Laststrom im Hauptstrompfad ansteigen und im parallelen Nebenstrompfad abnehmen lässt.

Betrachtet man den Nebenstrompfad durch die Kelvin-Quellen-Anschlüsse, welcher parallel zu dem Hauptstrompfad verläuft, den sogenannten "Kelvinpfad", so stellt man fest, dass gemäß einer bevorzugten Ausgestaltung der Erfindung in diesem Nebenstrompfad die beiden Steuer-Vorwiderstände liegen. Daraus ergibt sich in dem Kelvinpfad ein deutlich höherer Gesamtwiderstand verglichen zu dem elektrischen Widerstand in dem Strompfad durch die Power-Quellen-Anschlüsse, dem sogenannten "Hauptstrompfad", da die Anschlüsse selbst - sowohl die Kelvin-Quellen-Anschlüsse als auch die Power-Quellen-Anschlüsse - durch ihren internen Aufbau relativ niederohmig ausgeführt werden (z. B. mit Widerstandswerten < 1 Milli-Ohm: Die Kelvin-Quellen-Anschlüsse haben deutlich dünnere Bonddrähte gegenüber den Bonddrähten der Power-Quellen-Anschlüsse. Sie sind also nicht so niederohmig wie möglich, sondern sie sind so niederohmig wie nötig.) und die Steuer-Vorwiderstände weisen üblicherweise Widerstandswerte auf, die im ein- bis maximal zweistelligen Ohm-Bereich liegen. Nimmt man zum Beispiel an, dass der Kelvin-Quellen-Anschluss eines Transistors und der Power-Quellen-Anschluss eines Transistors jeweils einen Widerstand von 1 Milli-Ohm aufweist und der Steuer-Vorwiderstand eines Transistors einen Widerstandswert von 1 Ohm aufweist, so ergibt sich daraus bei zwei in Reihe geschalteten Widerständen ein um ca. 2000-fach oder mehr höherer Widerstand im Nebenstrompfad ("Kelvinpfad") als im Hauptstrompfad, weshalb auch maximal ein Zweitausendstel des Laststroms durch den Parallelstrompfad fließt. Somit fließt kein nennenswerter Anteil des Laststroms mehr durch die Kelvin-Quellen-Anschlüsse, und somit ist auch keine Überlastung der Kelvin-Quellen-Anschlüsse zu befürchten, obwohl die Vorteile der Kelvin-Quellen-Anschlüsse hinsichtlich des Schaltverhaltens erhalten bleiben.

Ein wesentlicher Vorteil der bevorzugten Ausgestaltung der Erfindung liegt also darin, dass auch für AC-Halbleiterschalter und bidirektionale DC-Halbleiterschalter in Common-Source-Konfiguration mit Kelvin-Anschlüssen die Vorteile der Kelvin-Anschlüsse genutzt werden können, ohne dass dafür eine Überlastung des Halbleiters in Kauf genommen werden muss: Der Laststrom über den zum Hauptstrompfad parallelen Nebenstrompfad durch die beiden Kelvin-Quellen-Anschlüsse, der sogenannte "Kelvinpfad", wird signifikant reduziert.

Gemäß einer bevorzugten Ausgestaltung der Erfindung ist der elektrische Widerstand in dem Nebenstrompfad aufgrund des mindestens einen Steuer-Vorwiderstands, der in dem Nebenstrompfad angeordnet ist, mindestens um einen Faktor Zehn größer ist als der elektrische Widerstand in dem Hauptstrompfad. Von Vorteil ist dabei, dass der Laststrom über den zum Hauptstrompfad parallelen Nebenstrompfad gegenüber dem Laststrom durch den Hauptstrompfad signifikant reduziert wird.

Gemäß einer bevorzugten Ausgestaltung der Erfindung ist der elektrische Widerstand in der elektrischen Verbindung der Kelvin-Quellen-Anschlüsse mindestens um einen Faktor Zehn größer als der elektrische Widerstand in der elektrischen Verbindung der Power-Quellen-Anschlüsse. Von Vorteil ist dabei, dass der Laststrom über den zum Hauptstrompfad parallelen Strompfad durch die beiden Kelvin-Quellen-Anschlüsse ("Kelvinpfad") gegenüber dem Laststrom durch den Hauptstrompfad signifikant reduziert wird.

Gemäß einer bevorzugten Ausgestaltung der Erfindung ist der elektrische Widerstand in dem Nebenstrompfad aufgrund des mindestens einen Steuer-Vorwiderstands, der in dem Nebenstrompfad angeordnet ist, mindestens um einen Faktor Eintausend größer ist als der elektrische Widerstand in dem Hauptstrompfad. Von Vorteil ist dabei, dass der Laststrom über den zum Hauptstrompfad parallelen Nebenstrompfad gegenüber dem Laststrom durch den Hauptstrompfad vernachlässigbar klein wird.

Gemäß einer bevorzugten Ausgestaltung der Erfindung ist mindestens einer der Transistoren ein MOSFET, ein IGBT oder ein Bipolartransistor. Von Vorteil ist dabei, dass marktübliche und daher kostengünstige Transistoren verwendbar sind.

Gemäß einer bevorzugten Ausgestaltung der Erfindung sind die elektrisch verbundenen Steuer-Anschlüsse mit einem Steueranschluss-Treiber verbunden. Von Vorteil ist dabei, dass für eine Ansteuerung des bidirektionalen Halbleiterschalters ein einkanaliger Gatetreiber ausreichend ist.

Gemäß einer bevorzugten Ausgestaltung der Erfindung ist in den beiden Steuer-Stromkreisen ein den beiden Steuer-Stromkreisen gemeinsamer Steueranschluss-Treiber angeordnet, d.h. die beiden Steuer-Stromkreise teilen sich denselben Steueranschluss-Treiber (= Gatetreiber). Von Vorteil ist dabei, dass für eine Ansteuerung des bidirektionalen Halbleiterschalters ein einkanaliger Gatetreiber ausreichend ist, der kostengünstiger als ein zweikanaliger Gatetreiber ist.

### Exemplarische Ausführungsbeispiele der Zeichnung

Die oben beschriebenen Eigenschaften, Merkmale und Vorteile dieser Erfindung sowie die Art und Weise, wie diese erreicht werden, werden klarer und deutlicher verständlich durch die folgende Beschreibung der Ausführungsbeispiele, welche anhand der Zeichnungen näher erläutert werden. Es zeigt jeweils schematisch und nicht maßstabsgetreu
- Fig. 1: einen bekannten 4-Pin-Transistor;
- Fig. 2: eine bekannte Common-Source-Konfiguration mit zwei 4-Pin-Transistoren und je einem Gate-Vorwiderstand in den beiden Gate-Steuerkreisen;
- Fig. 3: eine bekannte Common-Source-Konfiguration mit zwei 4-Pin-Transistoren und einem gemeinsamen Gate-Vorwiderstand für beide Gate-Steuerkreise;
- Fig. 4: eine bekannte "einfache" Common-Source-Konfiguration mit zwei 3-Pin-Transistoren;
- Fig. 5: eine bekannte "verbesserte" Common-Source-Konfiguration mit zwei 3-Pin-Transistoren und je einem Gate-Vorwiderstand in den beiden Gate-Steuerkreisen;
- Fig. 6: die bekannte "verbesserte" Common-Source-Konfiguration von Fig. 5 mit einem gemeinsamen Gate-Vorwiderstand für beide Gate-Steuerkreise;
- Fig. 7: eine erfindungsgemäße Common-Source-Konfiguration mit zwei 4-Pin-Transistoren;
- Fig. 8: eine erfindungsgemäße Common-Source-Konfiguration mit zwei 3-Pin-Transistoren;
- Fig. 9: einen MOSFET in der Ausführung TO-247-4;
- Fig. 10: einen MOSFET in der Ausführung TO-247-3;
- Fig. 11: einen 3-Pin-IGBT mit Diode; und
- Fig. 12: einen 4-Pin-IGBT mit Diode.

### Detaillierte Beschreibung der Ausführungsbeispiele

Fig. 1 zeigt einen herkömmlichen 4-Pin-Transistor T, d. h. einen Transistor mit einem Kelvin-Quellen-Anschluss K. Der dargestellte Transistor ist ein MOSFET. Außer dem Kelvin-Quellen-Anschluss K weist der Transistor T selbstverständlich einen Senkenanschluss D ("Drain"), einen Power-Quellen-Anschluss S ("Source") und einen Steueranschluss G ("Gate") auf. Jeder der vier Transistor-Anschlüsse D, G, K, S weist eine nichtverschwindende, parasitäre Induktivität L auf: in der Fig. 1 sind die Induktivitäten der Anschlüsse D, G, K, S durch das elektrische Symbol für Induktivität ("Leiterschleifen") symbolisiert und mit den Bezugszeichen Lx gekennzeichnet, wobei x jeweils durch eines der Bezugszeichen D, G, K, S der Anschlüsse ersetzt ist. Der Kelvin-Quellen-Anschluss K und der Power-Quellen-Anschluss S sind an einem Verzweigungspunkt P mit dem internen Quellen-Anschluss S' des Transistors elektrisch verbunden. Das heißt, auch bei Transistoren mit vier von außen elektrisch kontaktierbaren Anschlüssen erfolgt die Steuerung des Stroms oder der Spannung mithilfe von lediglich drei internen Anschlüssen, aber der interne Quellen-Anschluss S' des Transistors T verzweigt sich auf seinem Strompfad nach außen, zu den Anschlüssen K und S, in zwei Anschlüsse, nämlich den Power-Quellen-Anschluss S und den Kelvin-Quellen-Anschluss K. Der MOSFET-Transistor T weist intrinsisch eine Body-Diode auf.

Fig. 2 zeigt einen herkömmlichen bidirektionalen Halbleiterschalter in Common-Source-Konfiguration, mit zwei 4-Pin-Transistoren, hier: MOSFET, und je einem Gate-Vorwiderstand in den beiden Gate-Steuerkreisen. Der bidirektionale Halbleiterschalter weist zwei 4-Pin-Transistoren T1, T2 auf, einen ersten 4-Pin-Transistor T1 und einen zweiten 4-Pin-Transistor T2. Die Transistoren weisen jeweils einen Steuer-Anschluss G1, G2, einen Senken-Anschluss D1, D2, einen Power-Quellen-Anschluss S1, S2, und einen Kelvin-Quellen-Anschluss K1, K2 auf. Dabei sind die Steuer-Anschlüsse G1, G2 der zwei Transistoren T1, T2 in einem Steueranschluss-Kontaktpunkt GD elektrisch verbunden. Dabei sind die Power-Quellen-Anschlüsse S1, S2 der zwei Transistoren T1, T2 in einem Power-Quellen-Anschluss-Kontaktpunkt 8 elektrisch verbunden. Und dabei sind die Kelvin-Quellen-Anschlüsse K1, K2 der zwei Transistoren T1, T2 in einem Kelvin-Quellen-Anschluss-Kontaktpunkt 6 elektrisch verbunden. Der Kelvin-Quellen-Anschluss K1 und der Power-Quellen-Anschluss S1 des ersten Transistors T1 sind an einem Verzweigungspunkt P1 des ersten Transistors T1 mit einem internen Quellen-Anschluss S'1 des ersten Transistors T1 elektrisch verbunden. Der Kelvin-Quellen-Anschluss K2 und der Power-Quellen-Anschluss S2 des zweiten Transistors T2 sind an einem Verzweigungspunkt P2 des zweiten Transistors T2 mit einem internen Quellen-Anschluss S'2 des zweiten Transistors T2 elektrisch verbunden.

Die elektrisch miteinander verbundenen Steuer-Anschlüsse G1, G2 der zwei Transistoren T1, T2 sind in dem Steueranschluss-Kontaktpunkt GD mit einem Steueranschluss-Treiber 4 (Spannungsquelle) elektrisch verbunden. Um die Vorteile der Kelvin-Quellen-Anschlüsse K1, K2 zu nutzen, sind die beiden Kelvin-Quellen-Anschlüsse K1, K2 in dem Kelvin-Quellen-Anschluss-Kontaktpunkt 6 miteinander verbunden und bilden das Bezugspotential des Steueranschluss-Treibers 4, der die Ausgangsspannung und den Ausgangsstrom bereitstellt. Zwischen dem Steueranschluss-Kontaktpunkt GD und dem Transistor T1, T2 weisen die Steuer-Anschlüsse G1, G2 jeweils einen Steuer-Vorwiderstand R1, R2 auf, mit dem das Schaltverhalten angepasst werden kann.

Der Steueranschluss-Treiber 4 ist außerdem in dem Kelvin-Quellen-Anschluss-Kontaktpunkt 6 mit den elektrisch miteinander verbundenen Kelvin-Quellen-Anschlüssen K1, K2 der zwei Transistoren T1, T2 elektrisch verbunden. Somit ergeben sich zwei Steuer-Stromkreise 31, 32 mit dem Steueranschluss-Treiber 4 als gemeinsame Spannungsquelle: ein erster Steuer-Stromkreis 31 zum Steuern des ersten Transistors T1 und ein zweiter Steuer-Stromkreis 32 zum Steuern des zweiten Transistors T2.

Die für einen bidirektionalen Schalter notwendigen, antiparallel zu den Transistoren T1, T2 geschalteten Dioden sind intrinsisch im MOSFET vorhanden. Nur beim IGBT müssen diese Dioden durch externe Bauelemente aufgebaut werden, da ein IGBT durch seinen abschließenden P-Kanal-Layer diese Diode nicht intrinsisch besitzt; diesbezüglich wird auf Fig. 11 und Fig. 12 verwiesen.

Der bidirektionale Halbleiterschalter leitet einen Laststrom zwischen den beiden Senken-Anschlüssen D1, D2 auf zwei parallelen Strompfaden: Zum einen auf einem Hauptstrompfad 10, der die in dem Power-Quellen-Anschluss-Kontaktpunkt 8 miteinander verbundenen Power-Quellen-Anschlüsse S1, S2 umfasst. Zum anderen auf einem Nebenstrompfad = Kelvinpfad 12, der die in dem Kelvin-Quellen-Anschluss-Kontaktpunkt 6 miteinander verbundenen Kelvin-Quellen-Anschlüsse K1, K2 umfasst.

Die Aufteilung des Laststromes ist im Wesentlichen durch die internen Eigenschaften (z. B. Widerstände) des bidirektionale Halbleiterschalters abhängig. Der Kelvinpfad 12 ist jedoch nicht für hohe und andauernde Ströme ausgelegt, weshalb Hersteller von 4-Pin-Transistoren üblicherweise sogar davon abraten, die Kelvin-Quellen-Anschlüssen K1, K2 der zwei Transistoren T1, T2 in Common-Source-Konfiguration zu verwenden. Technisch funktioniert es also, die Kelvin-Quellen-Anschlüssen K1, K2 nicht zu benutzen, wodurch aber natürlich auch die positiven Effekte, die durch Verwendung der Kelvin-Quellen-Anschlüsse K1, K2 erzielbar sind, hinfällig werden. Das größere Problem mit dem Nebenstrompfad = Kelvinpfad 12 ist aber, dass er einen störenden Schwingkreis ausbilden kann.

Fig. 3 zeigt, analog zu Fig. 2, eine alternative bekannte Common-Source-Konfiguration mit zwei 4-Pin-Transistoren. Im Gegensatz zu der in Fig. 2 gezeigten Common-Source-Konfiguration, in der jeder der Steuer-Stromkreise 31, 32 einen eigenen Steuer-Vorwiderstand R1, R2 aufweist, weist die in Fig. 3 gezeigten Common-Source-Konfiguration einen gemeinsamen Steuer-Vorwiderstand R12 für beide Steuer-Steuerkreise 31, 32 auf. Abgesehen davon sind die in Fig. 2 und Fig. 3 gezeigten Common-Source-Konfiguration identisch.

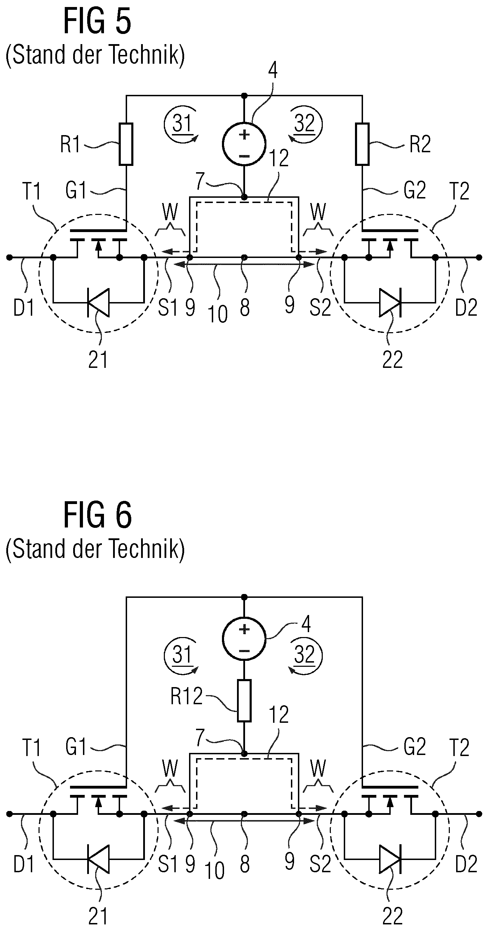

Fig. 4 zeigt eine bekannte "einfache" Common-Source-Konfiguration mit zwei 3-Pin-Transistoren T1, T2. Dabei handelt es sich um MOSFET: die explizit gezeichneten Dioden 21, 22 symbolisieren die intrinsisch im MOSFET vorhandenen Body-Dioden. Die beiden Source-Anschlüsse S1, S2 der Transistoren T1, T2 sind in dem Source-Anschluss-Kontaktpunkt 8 elektrisch verbunden. Die beiden Gate-Anschlüsse G1, G2 der Transistoren T1, T2 sind jeweils in einem Steuer-Stromkreis 31, 32 angeordnet, jeweils mit einem separaten Steuer-Vorwiderstand R1, R2. Die beiden Steuer-Stromkreise 31, 32 werden von einem gemeinsamen Steueranschluss-Treiber 4 mit Spannung versorgt. Die Steuer-Stromkreise 31, 32 verlaufen jeweils von dem Steueranschluss-Treiber 4 über den Source-Anschluss-Kontaktpunkt 8 bis zu den beiden Source-Anschlüssen S1, S2 und von dort über die Gate-Anschlüsse G1, G2 zurück zum Steueranschluss-Treiber 4. Ein wesentlicher Nachteil, der gegen diese "einfache" Schaltung spricht, ist, dass die Wegstrecken w der Steuer-Stromkreise 31, 32, die mit dem Hauptstrompfad 10 zusammenfallen, relativ lang sind: da auf diesen Strecken w ein signifikanter Induktivitätsbelag vorhanden ist, wird das Schaltverhalten der Steuer-Stromkreise 31, 32 deutlich verschlechtert. Genau das motiviert dazu, den Hauptstrompfad 10 möglichst früh von den Steuer-Stromkreisen 31, 32 zu trennen, wie in Fig. 5 dargestellt. Und genau das ist auch eine Motivation, Transistoren mit einer Kelvinsource auszustatten.

Fig. 5 zeigt eine bekannte "verbesserte" Common-Source-Konfiguration mit zwei 3-Pin-Transistoren und je einem Steuer-Vorwiderstand R1, R2 in den beiden Steuer-Steuerkreisen 31, 32. Die Verbesserung der in Fig. 5 gezeigten Common-Source-Konfiguration gegenüber der in Fig. 4 gezeigten Common-Source-Konfiguration besteht darin, dass die Wegstrecken w der Steuer-Stromkreise 31, 32, die mit dem Hauptstrompfad 10 zusammenfallen, verkürzt wurden. Auf diese Weise wurde die Induktivität in den Steuer-Stromkreise 31, 32 verringert und somit deren Schaltverhalten verbessert. Die Verkürzung der Wegstrecken w wurde dadurch erreicht, dass der bisher gemeinsame Abschnitt der Steuer-Stromkreise 31, 32 zwischen dem GND (-) des Steueranschluss-Treibers 4 und dem Hauptstrompfad 10 in einem Verzweigungspunkt 7 in zwei separate Einzelzweige der Steuer-Stromkreise 31, 32 geteilt wird, die dann jeweils an einem Trennungspunkt 9 auf den Hauptstrompfad 10 treffen. Auf diese Weise wird durch die zwei separaten Einzelzweige der Steuer-Stromkreise 31, 32, die sich jeweils zwischen dem Verzweigungspunkt 7 und dem Trennungspunkt 9 erstrecken, ein Nebenstrompfad 12 des Laststroms geschaffen.

Fig. 6 zeigt die bekannte "verbesserte" Common-Source-Konfiguration von Fig. 5 mit einem gemeinsamen Steuer-Vorwiderstand für beide Steuer-Steuerkreise 31, 32. Im Gegensatz zu der in Fig. 5 gezeigten Common-Source-Konfiguration, in der jeder der Steuer-Stromkreise 31, 32 einen eigenen Steuer-Vorwiderstand R1, R2 aufweist, weist die in Fig. 6 gezeigten Common-Source-Konfiguration einen gemeinsamen Steuer-Vorwiderstand R12 für beide Steuer-Steuerkreise 31, 32 auf. Abgesehen davon sind die in Fig. 5 und Fig. 6 gezeigten Common-Source-Konfigurationen identisch.

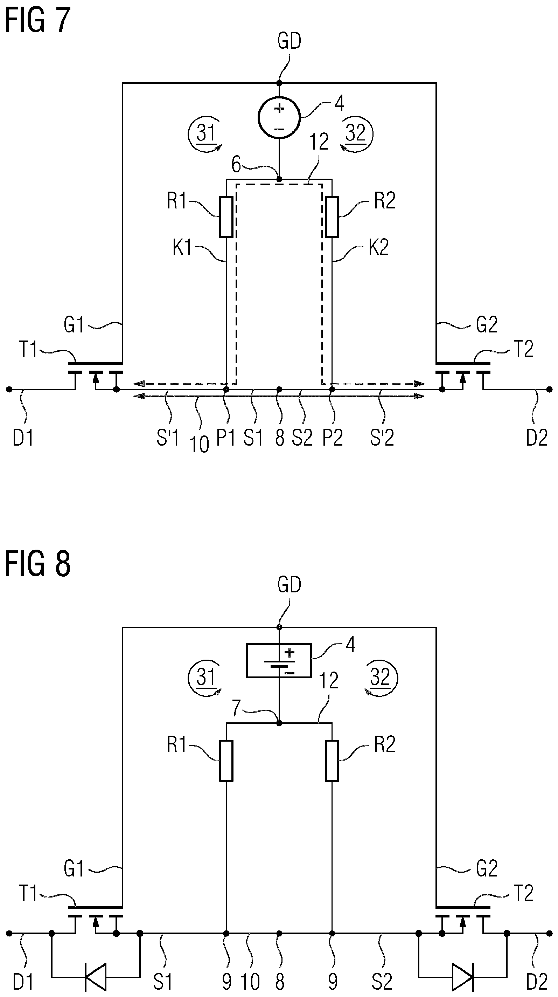

Fig. 7 zeigt einen erfindungsgemäßen bidirektionalen Halbleiterschalter in Common-Source-Konfiguration mit zwei 4-Pin-Transistoren. Er entspricht weitgehend dem in Fig. 2 gezeigten herkömmlichen bidirektionalen Halbleiterschalter in Common-Source-Konfiguration, allerdings mit dem entscheidenen Unterschied, dass die Steuer-Vorwiderstände R1, R2 im Nebenstrompfad 12 angeordnet sind. Durch die Steuer-Vorwiderstände R1, R2 im Nebenstrompfad 12 fließt also nur noch ein relativ geringer, vorzugsweise vernachlässigbarer Teil des Laststroms über den Nebenstrompfad 12, der weitaus größte Anteil des Laststroms aber über den für den Laststrom ausgelegten Hauptstrompfad 10. Somit fließt kein nennenswerter Laststrom mehr durch den Nebenstrompfad = Kelvinpfad 12, und damit ist auch keine Überlastung der Kelvin-Quellen-Anschlüsse K1, K2 zu befürchten; trotzdem bleiben die Vorteile beim Schaltverhalten, die durch die Verwendung der Kelvin-Quellen-Anschlüsse K1, K2 erreicht werden können, erhalten.

Fig. 8 zeigt eine erfindungsgemäße Common-Source-Konfiguration mit zwei 3-Pin-Transistoren. Um das erfindungswesentliche Merkmal dieser erfindungsgemäßen Common-Source-Konfiguration zu erkennen, ist sie zu vergleichen mit der in Fig. 5 gezeigten bekannten "verbesserten" Common-Source-Konfiguration. Die in Fig. 8 dargestellte Common-Source-Konfiguration entspricht weitgehend der in Fig. 5 gezeigten herkömmlichen Common-Source-Konfiguration, allerdings mit dem entscheidenden Unterschied, dass die Steuer-Vorwiderstände R1, R2 im Nebenstrompfad 12 angeordnet sind. Durch die Steuer-Vorwiderstände R1, R2 im Nebenstrompfad 12 fließt also nur noch ein relativ geringer, vorzugsweise vernachlässigbarer Teil des Laststroms über den Nebenstrompfad 12, der weitaus größte Anteil des Laststroms aber über den für den Laststrom ausgelegten Hauptstrompfad 10.

Fig. 9 zeigt einen bekannten 4-Pin-MOSFET in der Ausführung mit einem Gehäuse TO-247-4. Der 4-Pin-MOSFET weist einen Kelvin-Quellen-Anschluss K, einen Senkenanschluss D ("Drain"), einen Power-Quellen-Anschluss S ("Source") und einen Steueranschluss G ("Gate") auf.

Fig. 10 zeigt einen bekannten 3-Pin-MOSFET in der Ausführung mit einem Gehäuse TO-247-3. Der 3-Pin-MOSFET weist einen einen Senkenanschluss D ("Drain"), einen Quellen-Anschluss S ("Source") und einen Steueranschluss G ("Gate") auf.

Fig. 11 zeigt ein Schaltbild eines bekannten 3-Pin-IGBT mit separater Freilauf-Diode; während ein MOSFET intrinsisch eine Body-Diode aufweist, muss ein IGBT, der keine intrinsische Diode aufweist, separat mit einer Diode ausgestattet werden, falls es eine bidirektionale Anwendung erfordert. Ein solcher 3-Pin-IGBT kann in einem Gehäuse TO-247-3 eingehaust sein. Der 3-Pin-IGBT weist einen einen Senkenanschluss C ("Collector"), einen Quellen-Anschluss E ("Emitter") und einen Steueranschluss G ("Gate") auf.

Fig. 12 zeigt ein Schaltbild eines bekannten 4-Pin-IGBT mit separater Freilauf Diode. Ein solcher 4-Pin-IGBT kann in einem Gehäuse TO-247-4 eingehaust sein. Der 4-Pin-IGBT weist einen Kelvin-Quellen-Anschluss E' ("Kelvin-Emitter" oder "Hilfs-Emitter"), einen Power-Quellen-Anschluss E ("Emitter"), einen Senkenanschluss C ("Collector") und einen Steueranschluss G ("Gate") auf.

### Bezugszeichenliste

- 4: Steueranschluss-Treiber
- 6: Kelvin-Quellen-Anschluss-Kontaktpunkt
- 7: Verzweigungspunkt von GND
- 8: Power-Quellen-Anschluss-Kontaktpunkt, Source-Abschluss-Kontaktpunkt
- 9: Trennungspunkt Hauptstrompfad - Steuer-Stromkreis
- 10: Hauptstrompfad
- 12: Nebenstrompfad
- 21: Diode
- 22: Diode
- 31: Steuerstromkreis
- 32: Steuerstromkreis
- D: Senkenanschluss von T
- D1: Senkenanschluss von T1
- D2: Senkenanschluss von T2
- GD: Steueranschluss-Kontaktpunkt
- G: Steueranschluss von T
- GND: Masse
- G1: Steueranschluss von T1
- G2: Steueranschluss von T2
- K: Kelvin-Quellen-Anschluss von T
- K1: Kelvin-Quellen-Anschluss von T1
- K2: Kelvin-Quellen-Anschluss von T2
- LD: Induktivität von D
- LG: Induktivität von G
- LK: Induktivität von K
- LS: Induktivität von S
- P: Verzweigungspunkt von T
- P1: Verzweigungspunkt von T1
- P2: Verzweigungspunkt von T2
- R1: Steuer-Vorwiderstand von T1
- R2: Steuer-Vorwiderstand von T2
- S: Power-Quellen-Anschluss von T
- S1: Power-Quellen-Anschluss von T1
- S2: Power-Quellen-Anschluss von T2
- S': interner Quellen-Anschluss von T
- S'1: interner Quellen-Anschluss von T1
- S'2: interner Quellen-Anschluss von T2
- T: Transistor
- T1: Transistor, erster, des Bidirektionalen Halbleiterschalters
- T2: Transistor, zweiter, des Bidirektionalen Halbleiterschalters

## Patentansprüche

1. Common-Source-Konfiguration von zwei Transistoren (T1, T2), aufweisend
- zwei Steuer-Stromkreise (31, 32) zur Steuerung je eines der Transistoren (T1, T2), um einen Laststrom durch die Common-Source-Konfiguration zu steuern,
- einen Hauptstrompfad (10) des Laststroms, und
- einen Nebenstrompfad (12) des Laststroms, der parallel zu einem Abschnitt des Hauptstrompfads (10) verläuft,
wobei in mindestens einem der Steuer-Stromkreise (31, 32) ein oder mehrere Steuer-Vorwiderstände (R1, R2, R12) angeordnet sind,
wobei
- ein erster Transistor (T1) der zwei Transistoren (T1, T2) einen ersten Quellen-Anschluss (S1), einen ersten Senken-Anschluss (D1) und einen ersten Steuer-Anschluss (G1) aufweist,
- ein zweiter Transistor (T2) der zwei Transistoren (T1, T2) einen zweiten Quellen-Anschluss (S1), einen zweiten Senken-Anschluss (D1) und einen zweiten Steuer-Anschluss (G1) aufweist,
wobei die beiden Quellen-Anschlüsse (S1, S2) elektrisch verbunden sind,
wobei die beiden Senken-Anschlüsse (D1, D2) und die beiden Quellen-Anschlüsse (S1, S2) in dem Hauptstrompfad (10) liegen,
wobei in einem ersten Steuer-Stromkreis (31) der Steuer-Stromkreise (31, 32), der zur Steuerung des ersten Transistors (T1) dient, eine erste Steuereinheit (4), ein erster Steuer-Vorwiderstand (R1) und der erste Steuer-Anschluss (G1) liegt,
wobei in einem zweiten Steuer-Stromkreis (32) der Steuer-Stromkreise (31, 32), der zur Steuerung des zweiten Transistors (T2) dient, eine zweite Steuereinheit (4), ein zweiter Steuer-Vorwiderstand (R2) und der zweite Steuer-Anschluss (G2) liegt,
wobei parallel zu einem Teilstück des Hauptstrompfades (10) der Nebenstrompfad (12) verläuft, dessen eine Hälfte durch ein Teilstück des ersten Steuer-Stromkreises (31) und dessen andere Hälfte durch ein Teilstück des zweiten Steuer-Stromkreises (32) gebildet wird,
**dadurch gekennzeichnet,**
**dass** mindestens einer der besagten Steuer-Vorwiderstände (R1, R2, R12) im Nebenstrompfad (12) angeordnet ist.

2. Common-Source-Konfiguration nach Anspruch 1, wobei
die erste Steuereinheit (4) und die zweite Steuereinheit (4) identisch sind.

3. Common-Source-Konfiguration nach einem der vorhergehenden Ansprüche,
wobei die zwei Transistoren (T1, T2) jeweils vier Anschlüsse, umfassend einen Steuer-Anschluss (G1, G2), einen Senken-Anschluss (D1, D2), einen Power-Quellen-Anschluss (S1, S2) und einen Kelvin-Quellen-Anschluss (K1, K2), aufweisen,
wobei der Nebenstrompfad (12) durch die beiden miteinander verbundenen Kelvin-Quellen-Anschlüsse (K1, K2) gebildet ist.

4. Common-Source-Konfiguration nach einem der vorhergehenden Ansprüche, wobei der elektrische Widerstand in dem Nebenstrompfad (12) aufgrund des mindestens einen Steuer-Vorwiderstands (R1, R2, R12), der in dem Nebenstrompfad (12) angeordnet ist, mindestens um einen Faktor Zehn größer ist als der elektrische Widerstand in dem Hauptstrompfad (10).

5. Common-Source-Konfiguration nach Anspruch 4, wobei der elektrische Widerstand in dem Nebenstrompfad (12) aufgrund des mindestens einen Steuer-Vorwiderstands (R1, R2, R12), der in dem Nebenstrompfad (12) angeordnet ist, mindestens um einen Faktor Eintausend größer ist als der elektrische Widerstand in dem Hauptstrompfad (10).

6. Common-Source-Konfiguration nach einem der vorhergehenden Ansprüche, wobei mindestens einer der Transistoren ein MOSFET, ein IGBT oder ein Bipolartransistor ist.

7. Common-Source-Konfiguration nach einem der vorhergehenden Ansprüche, wobei in den Steuer-Stromkreisen (31, 32) ein den Steuer-Stromkreisen (31, 32) gemeinsamer Steueranschluss-Treiber (4) angeordnet ist.
